# EUROPEAN PATENT SPECIFICATION

(11) **EP 1 529 753 B1**
(45) Date of publication and mention of the grant of the patent: **13.09.2017**
(21) Application number: 04077867.2
(22) Date of filing: 19.10.2004
(51) Int. Cl.: B81C 1/00, H04R 19/00

(54) **Fabrication of ultrathin form factor mems microphones and microspeakers**
Herstellung von sehr dünnen MEMS Mikrophonen und Mikrolautsprechern
Fabrication de microphones et micro-haut-parleurs MEMS ultra-minces

(30) Priority: 05.11.2003 US 701860; 15.03.2004 US 800470
(43) Date of publication of application: 11.05.2005
(73) Proprietor: Akustica Inc., Pittsburgh, Pennsylvania 15203 (US)
(72) Inventor: Xu, Zhu, Pittsburgh, PA 15220 (US); Ciferno, Raymond A., Cranberry Twp., PA 16066 (US)
(74) Representative: DREISS Patentanwälte PartG mbB

(56) References cited:
- WO-A-01/20948
- DE-A1- 10 065 686
- DE-A1- 10 122 845
- DE-A1- 10 246 053
- US-A1- 2003 119 275
- US-B1- 6 573 156
- BAGDAHN J ET AL: "A new approach for handling and transferring of thin semiconductor materials" MICROSYSTEM TECHNOLOGIES SPRINGER-VERLAG GERMANY, vol. 9, no. 3, January 2003 (2003-01), pages 204-209, XP002355676 ISSN: 0946-7076
- PATENT ABSTRACTS OF JAPAN vol. 2003, no. 07, 3 July 2003 (2003-07-03) -& JP 2003 086539 A (HITACHI LTD), 20 March 2003 (2003-03-20)
- NING Y B ET AL: "Fabrication of a silicon micromachined capacitive microphone using a dry-etch process" SENSORS AND ACTUATORS A, ELSEVIER SEQUOIA S.A., LAUSANNE, CH, vol. 53, no. 1, May 1996 (1996-05), pages 237-242, XP004018152 ISSN: 0924-4247

## Description

### BACKGROUND

The present disclosure is directed generally to micro-electro-mechanical systems (MEMS) devices and, more particularly, to processing techniques for forming ultrathin devices.

The ability to form moving parts measured in microns has opened up a huge range of applications. Such moving parts typically take the form of a beam or mesh that may form, for example, a variable capacitor, switch, or other component. The recent ability to seal micro-machined meshes has lead to the fabrication of microphones and microspeakers. See, for example, International Publication No. WO/01/20948 A2 published 22 March 2001, entitled MEMS Digital-to-Acoustic Transducer With Error Cancellation.

A sealed mesh can function as a movable plate of a variable capacitor, and therefore can operate as a microspeaker or microphone. For a sealed mesh to operate as a microspeaker or microphone, the device needs to be able to push air to create a soundwave just as its larger counterparts must push air to create soundwaves. For example, traditional speaker enclosures have a port on the back to allow the speaker to move freely. In the case of a microspeaker or microphone, if the chamber beneath the sealed mesh does not have a vent or other opening to ambient, movement of the sealed mesh inward is inhibited by the inability to compress the air in the chamber while movement of the mesh outward is inhibited by formation of a vacuum. Thus it is necessary to form a vent in the chamber.

Currently, such vents are formed by boring through the substrate from the rear. That requires patterning the back side of the substrate followed by an etch through the entirety of the substrate to reach the chamber. Forming of vents by this technique is slow in that several hundred microns of substrate may need to be etched to reach the chamber beneath the sealed mesh and the diameter of the vent is small compared to its depth. Additionally, there are registration problems in that it is necessary to work from the back side of the substrate where there are no landmarks, and hundreds of microns may need to be etched to reach a chamber that may measure in the tens of microns.

U.S. patent application serial no. 10/349,618 entitled Process for Forming and Acoustically Connecting Structures on a Substrate, filed January 23, 2003 and published as US 2004/0146810 A1 discloses a processes in which the substrate is etched in the area of the mesh. Although that represents an improvement over the prior art, the need still exists for an easy, repeatable, fast process for forming vents in the chambers of sealed meshes that are to function as speakers or microphones. Bagdahn J., et al., "A new approach for handling and transferring of thin semiconductor materials", Microsystem Technologies Springer Verlag, Germany, vol. 9, No. 3, January 2003, pages 204-209, XP002355676, ISSN 0946-7076, and DE 100 656 86 A1 provide, in part, at least certain of the plurality of devices having micro-machined meshes, and releasing said micro-machines meshes.
US 6 557 977 B1 discloses ink jet printing device that utilizes a shape memory alloy such as a nickel titanium alloy for ejecting drops. According to US 6 557 997 B1 a glass blank is attached to a top side of a wafer.

### BRIEF SUMMARY

The present disclosure is directed to a CMOS process of fabricating a plurality of devices containing MEMS membranes (sealed micro-machined meshes) which begins with certain process steps being performed from the top side of a substrate carrying the plurality of devices. A carrier wafer is attached to the top side of the substrate. The thickness of the substrate is reduced using any known technique. The fabrication process is continued by performing various process steps from the back side of the substrate.

The present disclosure is also directed to a CMOS process of fabricating a plurality of devices containing MEMS membranes which begins with attaching a carrier wafer to a top side of a substrate carrying the plurality of devices. The thickness of the substrate is reduced. Process steps are then performed from the back side of the substrate. A carrier wafer is attached to the back side of the substrate and the carrier wafer on the top side of the substrate is removed. Thereafter, process steps are performed from the top side of the substrate.

This disclosure encompasses a process for fabricating a MEMS device in which the thickness of a substrate is reduced; a carrier wafer is attached to one of the top side and back side of the substrate during at least a part of the process of fabricating the MEMS device. The use of the carrier wafer may include a carrier wafer attached to the top side of the substrate to enable at least certain process steps to be performed from the back side of the substrate and/or use of a carrier wafer attached to the back side of the substrate to enable at least certain process steps to be performed from the top side of the substrate.

As the various embodiments of the disclosure indicate, the use of carrier wafers to support the thinned wafer enables process steps to be carried out on the side opposite from the side having the carrier wafer. As the different embodiments indicate, the side carrying the carrier wafer can be varied throughout the process. Those advantages and benefits, and others, will be apparent from the description appearing below.

### BRIEF DESCRIPTION OF THE DRAWINGS

For the present disclosure to be easily understood and readily practiced, the present disclosure will now be described, for purposes of illustration and not limitation, in conjunction with the following figures, wherein:
FIG. 1 illustrates a substrate having a plurality of metal layers patterned to form a device;
FIG. 2 illustrates the substrate of FIG. 1 after the thickness of the substrate has been reduced;
FIG. 3 illustrates the substrate of FIG. 2 after a carrier wafer has been attached to the back side of the substrate;
FIG. 4 illustrates the substrate of FIG. 3 after the top side has been patterned with a resist;
FIG. 5 illustrates the fabrication of the mesh as a result of an anisotropic etch;
FIG. 6 illustrates the substrate of FIG. 5 after the top side has been patterned with a resist;
FIG. 7 illustrates the formation of pilot openings using a portion of the mesh as an etch mask;
FIG. 8 illustrates the substrate of FIG. 7 after the mesh has been released and the pilot openings expanded to form vent holes;
FIG. 9 illustrates how a plurality of devices may be singulated by etching either as a separate step or in conjunction with a through-wafer vent hole etch process;
FIG. 10 illustrates how a plurality of devices may be singulated using conventional dicing;
FIG. 11 illustrates the substrate of FIG. 1 after the top side has been patterned with a resist;
FIG. 12 illustrates the fabrication of the mesh as a result of an anisotropic etch;
FIG. 13 illustrates the substrate of FIG. 12 after the top side has been covered with a protective layer;
FIG. 14 illustrates the substrate of FIG. 13 after the thickness of the substrate has been reduced;
FIG. 15 illustrates the substrate of FIG. 14 after a carrier wafer has been attached to the back side of the substrate and the protective layer has been removed from the top side of the substrate;
FIG. 16 illustrates the substrate of FIG. 15 after a layer of resist has been deposited and patterned to enable certain portions of the mesh to act as an etch mask for pilot openings to be formed in the substrate;
FIG. 17 illustrates the substrate of FIG. 16 after pilot openings have been formed as a result of an anisotropic etch;
FIG. 18 illustrates the substrate of FIG. 17 after the mesh has been released and the pilot openings expanded to form vent holes;
FIG. 19 illustrates the substrate of FIG. 5 after a second carrier wafer has been attached to the top side of the substrate; a protective material may fill gaps between carrier wafer and substrate;
FIG. 20 illustrates the substrate of FIG. 19 after the first carrier wafer has been removed from the back side of the substrate;
FIG. 21 illustrates the substrate of FIG. 20 after a layer of resist has been deposited and patterned on the back side of the substrate;
FIG. 22 illustrates the substrate of FIG. 21 after the formation of vent holes;
FIG. 23 illustrates the substrate of FIG. 22 after the attachment of a third carrier wafer to the back side of the substrate;
FIG. 24 illustrates the substrate of FIG. 23 after the second carrier has been removed from the top side of the substrate; the protective layer has also been removed.
FIG. 25 illustrates the substrate of FIG. 24 after the mesh has been released;
FIG. 26 illustrates the substrate of FIG. 5 after an isotropic etch has been performed to release the mesh;
FIG. 27 illustrates the substrate of FIG. 26 after a second carrier wafer has been attached to the top side of the substrate;
FIG. 28 illustrates the substrate of FIG. 27 after the first carrier wafer has been removed from the back side of the substrate;
FIG. 29 illustrates the substrate of FIG. 28 after a layer of resist has been patterned;
FIG. 30 illustrates the substrate of FIG. 29 after an etch has been performed to form vent holes;
FIG. 31 illustrates the substrate of FIG. 4 after the attachment of a second carrier wafer to the top side of the substrate and the removal of the first carrier wafer from the back side of the substrate; a protective layer may fill gaps between carrier wafer and substrate.
FIG. 32 illustrates the substrate of FIG. 31 after a layer of resist has been patterned on the back side of the substrate;
FIG. 33 illustrates the substrate of FIG. 32 after the formation of vent holes;
FIG. 34 illustrates the substrate of FIG. 33 with the remaining resist removed;
FIG. 35 illustrates the substrate of FIG. 34 after the attachment of a third carrier wafer to the back side of the substrate;
FIG. 36 illustrates the substrate of FIG. 35 after the removal of the second carrier wafer from the top side of the substrate;
FIG. 37 illustrates the fabrication of the mesh as a result of an anisotropic etch;
FIG. 38 illustrates the substrate of FIG. 37 after the mesh is released;
FIG. 39 illustrates the substrate of FIG. 1 after a layer of resist has been formed and patterned;
FIG. 40 illustrates the substrate of FIG. 39 after a carrier wafer has been attached to the top side of the substrate;
FIG. 41 illustrates the substrate of FIG. 40 after the substrate has been thinned;
FIG. 42 illustrates the substrate of FIG. 41 after a layer of resist has been formed and patterned on the back side of the substrate;
FIG. 43 illustrates the substrate of FIG. 42 after the formation of vent holes;
FIG. 44 illustrates the substrate of FIG. 43 after the resist has been removed;
FIG. 45 illustrates the substrate of FIG. 44 after a carrier wafer has been attached to the back side of the substrate;
FIG. 46 illustrates the substrate of FIG. 45 after the carrier wafer on the top side of the substrate has been removed;
FIG. 47 illustrates the fabrication of the mesh as a result of an anisotropic etch;
FIG. 48 illustrates the substrate of FIG. 47 after the mesh is released;
FIG. 49 illustrates the substrate of FIG. 1 after a layer of resist has been formed and patterned:
FIG. 50 illustrates the fabrication of the mesh on the substrate of FIG. 49 as a result of an anisotropic etch;
FIG. 51 illustrates the attachment of a carrier wafer to the top side of the substrate of FIG. 50 through the application of an adhesive layer with or without a cushion material interposed between the substrate and the carrier wafer;
FIG. 52 illustrates the substrate of FIG. 51 after the thickness of the substrate has been reduced;
FIG. 53 illustrates the substrate of FIG. 52 after a layer of resist has been formed and patterned on the back side of the substrate;
FIG. 54 illustrates the substrate of FIG. 53 after the formation of vent holes;
FIG. 55 illustrates the substrate of FIG. 54 after the resist has been removed;
FIG. 56 illustrates the substrate of FIG. 55 after a carrier wafer has been attached to the back side of the substrate;
FIG. 57 illustrates the substrate of FIG. 56 after the carrier wafer on the top side of the substrate has been removed; and
FIG. 58 illustrates the substrate of FIG. 57 after the mesh is released.

### DETAILED DESCRIPTION

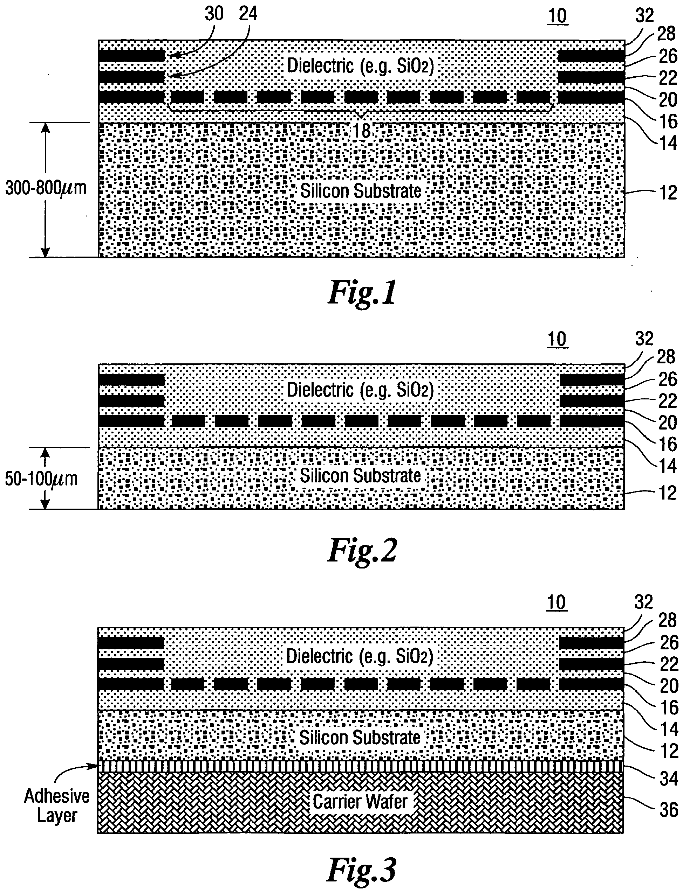

A first embodiment of the present disclosure is illustrated in conjunction with FIGs. 1 - 9. In FIG. 1, a wafer 10 (a portion of which is seen in FIG. 1) is received from a CMOS foundry. Those of ordinary skill in the art will recognize the wafer carries a plurality of devices, one of which is shown in FIG. 1. At the CMOS foundry, a silicon substrate 12 has been processed so as to form alternating layers of, for example, a dielectric material and a metal. The wafer 10 illustrated in FIG. 1 has a first layer of dielectric material 14 carrying a first metal layer 16. The first metal layer 16 has been patterned such that a portion thereof forms a micro-machined mesh 18. Formed on the first metal layer 16 is a second layer of dielectric 20. The second layer of dielectric 20 carries a second metal layer 22 which has been patterned to have an opening 24 formed therein. The second metal layer 22 carries a third layer of dielectric 26. The third layer of dielectric 26 carries a third layer of metal 28 which has been patterned to have an opening 30 formed therein. A top layer of dielectric 32 is formed on top of the third metal layer 28.

The present disclosure is not limited to the position and configuration of the metal layers shown in the figures. For example, the pattern shown in FIG. 1 could be implemented in metal layers two, three and four such that references herein to a first, second and third layers of metal need not correspond to metal layers one, two and three, respectively. Additionally, the configuration of the layers of metal need not be as shown in the figures but rather may vary depending upon the device to be fabricated.

As previously mentioned, the wafer 10 would be received, for example, as shown in FIG. 1 from the CMOS foundry. Thereafter, the wafer 10 will be subjected to post-processing fabrication steps. Although it is anticipated that the post-processing fabrication steps will take place in a facility different from the CMOS foundry which fabricated the wafer 10, that is not a requirement of the present disclosure.

Turning to FIG. 2, a CMP process, back side grinding, a reactive ion etch (RIE) a dry, reactive ion etch (DRIE) or other process is performed on the back side of the wafer 10 to thin the wafer to 50 - 100 µm. Depending on the process selected for thinning the wafer, it may be necessary to take steps to protect the top side of the wafer.

Turning to FIG. 3, a layer of adhesive 34 is used to attach a first carrier wafer 36 to the back side of the substrate 14. Openings (not shown) may be provided in the carrier wafer 36 and/or adhesive layer 34 to provide for cooling of the substrate 12. Additionally, those of ordinary skill in the art will recognize that, depending on the amount of substrate 14 being removed and the process being performed, it may be necessary to attach a temporary carrier wafer (not shown) to the top side of wafer 10 to provide support for the thinning process. If such a temporary support is needed, it is removed after first carrier wafer 36 is attached as shown in FIG. 3.

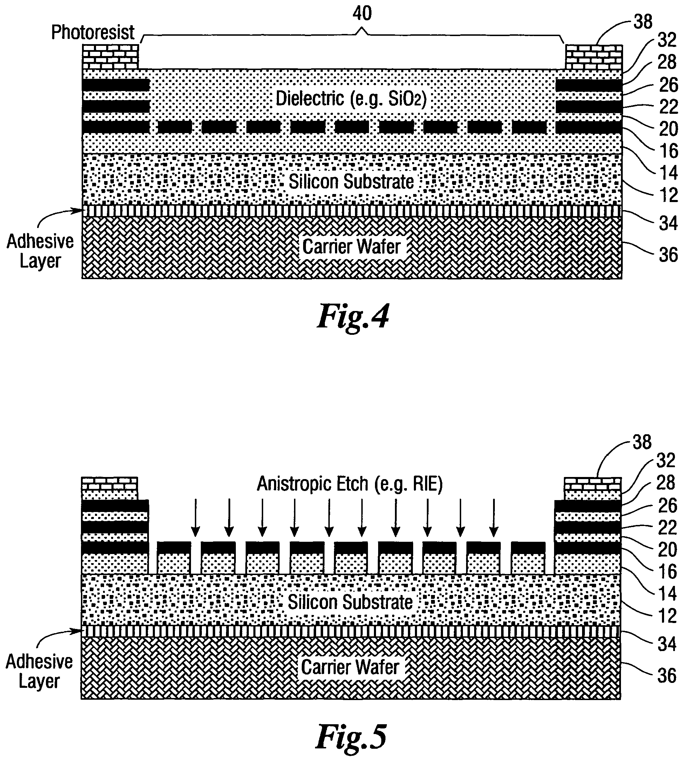

FIG. 4 illustrates the substrate 12 of FIG. 3 after a layer of resist 38 is formed (by any appropriate process) on the top side and patterned (by any appropriate process) to provide an opening 40 in the area of the mesh 18. In FIG. 5, the substrate 12 of FIG. 4 is illustrated being subjected to an anisotropic etch through the dielectric layers 32, 26, 20 and 14 to form the mesh. The patterned resist 38 and the first metal layer 16 are used to pattern the first dielectric layer 14. The layer of resist 38 may not be necessary if it is not necessary to protect the top layer of dielectric 32.

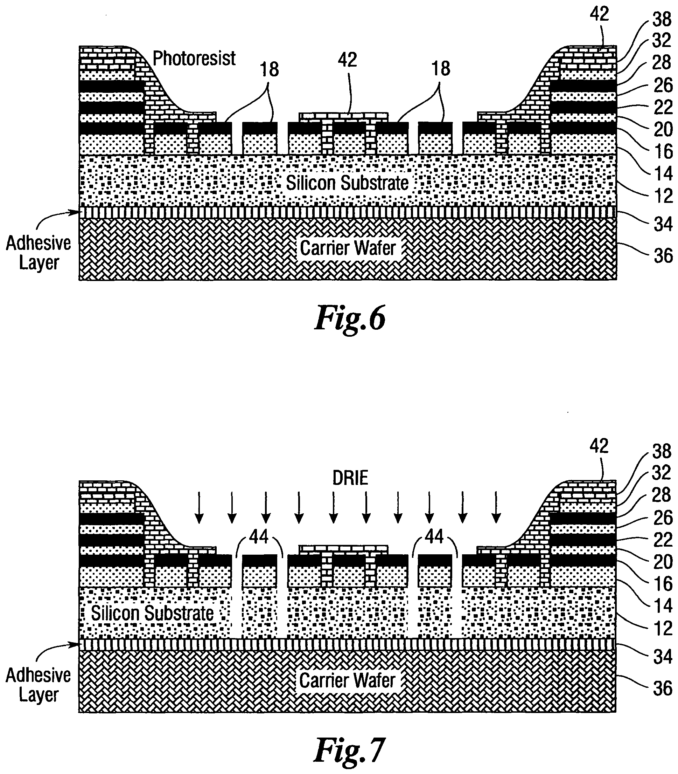

FIG. 6 illustrates the substrate of FIG. 5 after the top side has been patterned with a layer of resist 42 to enable certain portions of the mesh 18 to act as an etch mask for pilot openings to be formed in the substrate 12. FIG. 7 illustrates the substrate 12 of FIG. 6 being subjected to a DRIE anisotropic etch which forms pilot openings 44 extending through the silicon substrate 12 and stopping at the layer of adhesive 34.

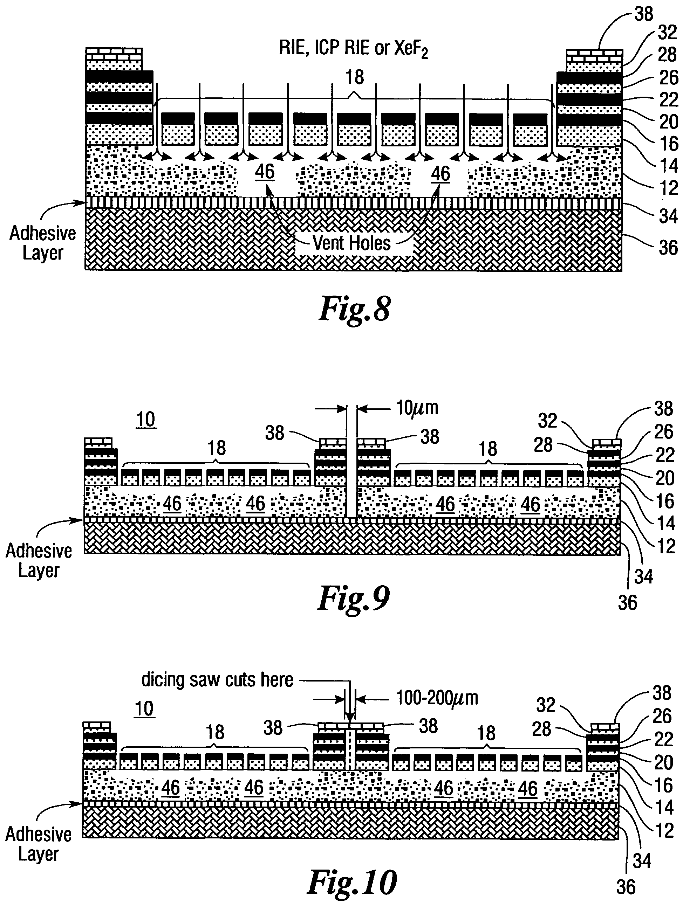

FIG. 8 illustrates the substrate 12 being subjected to an isotropic etch so as to release the mesh 18 from the substrate 12 by removal of the substrate material from under the mesh 18. Other forms of releasing the mesh could be provided, such as removal of a sacrificial layer (not shown). As the mesh 18 is being released, the pilot openings 44 are being expanded to form vent holes 46. Because the vent holes 46 are formed by enlarging the pilot openings 44, and the pilot openings 44 are formed by using a portion of the mesh 18 as an etch mask, the vent openings 46 will be in alignment under the released mesh 18.

FIG 9 illustrates a larger portion of the wafer 10 such that two adjacent devices carried by substrate 12 are illustrated. FIG 9 illustrates how a plurality of devices may be singulated by etching. The etching may be performed either as a separate step or in conjunction with the step of releasing the mesh 18 and/or forming vent holes 46 as illustrated in FIG 8. In FIG 9, it is seen that adjacent devices are laid out with a gap of approximately 10 µm between adjacent devices, although the gap can be varied by design, from a couple of microns to a couple of hundred microns. The layer of resist 38 is patterned such that while the mesh 18 is being released and the vent holes 46 are being formed, adjacent devices are being singulated. Alternatively, this singulation process could be performed separately, assuming an appropriate layer of resist was formed and patterned. However, because the releasing of the mesh 18 and formation of vent holes 46 is a through-wafer etch process, the singulation of the devices into separate chips can be completed at the same time. Thereafter, the adhesive layer can be de-adhered by heat, UV light or other means enabling each device (chip) to be picked up individually and packaged.

FIG. 10 illustrates how the wafer 10 may be singulated using a dicing saw as is known in the art. Because the dicing saw provides a cut of a approximately 65 µm, adjacent devices will likely be laid out with a spacing of 100 - 200 µm between adjacent devices. Such a spacing allows for dicing saws of different thicknesses to be used while ensuring that the devices are not harmed. After dicing with a dicing saw, the adhesive layer can be de-adhered thus leaving the individual chips to be picked up and packaged.

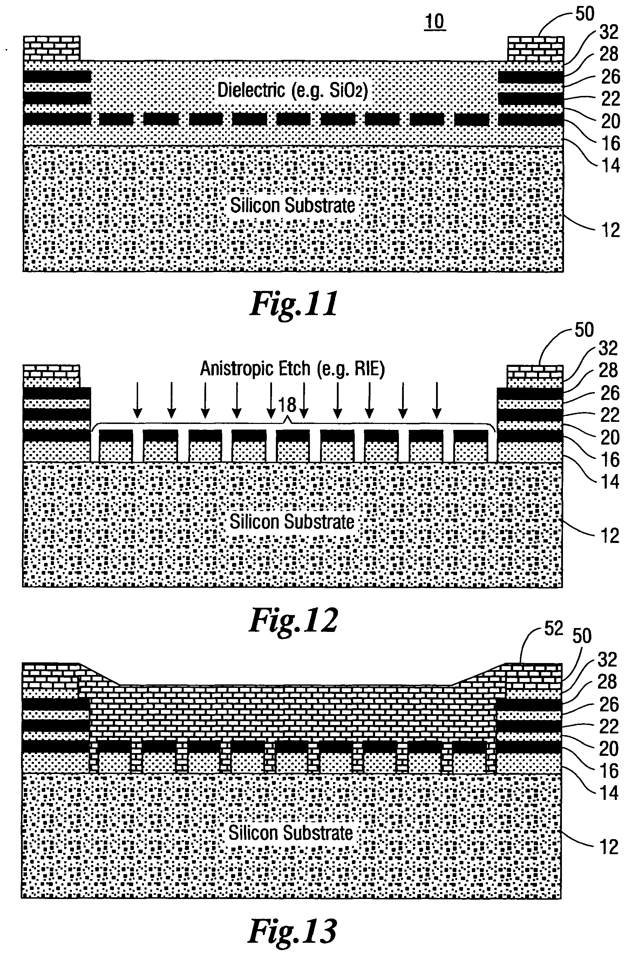

FIGs. 11 - 18 illustrate another embodiment of the present disclosure. The embodiment of FIG. 11 - 18 is similar to the first embodiment, except that the thinning of the wafer 10 occurs at a different point in the process. The process of FIGs. 11-18 begins with a wafer 10 of the type shown in FIG. 1. FIG. 11 illustrates the wafer 10 of FIG. 1 after the top side has been patterned with a resist 50.

Turning to FIG. 12, the substrate 12 of FIG. 11 is illustrated being subjected to an anisotropic etch through the dielectric layers 32, 26, 20 and 14. The patterned resist 50 and the first metal layer 16 are used to pattern the first dielectric layer 14 and to form mesh 18. The layer of resist 50 may not be necessary if it is not necessary to protect the top layer of dielectric 32. In FIG. 13, a protective layer of resist 52 is formed on the top side of wafer 10.

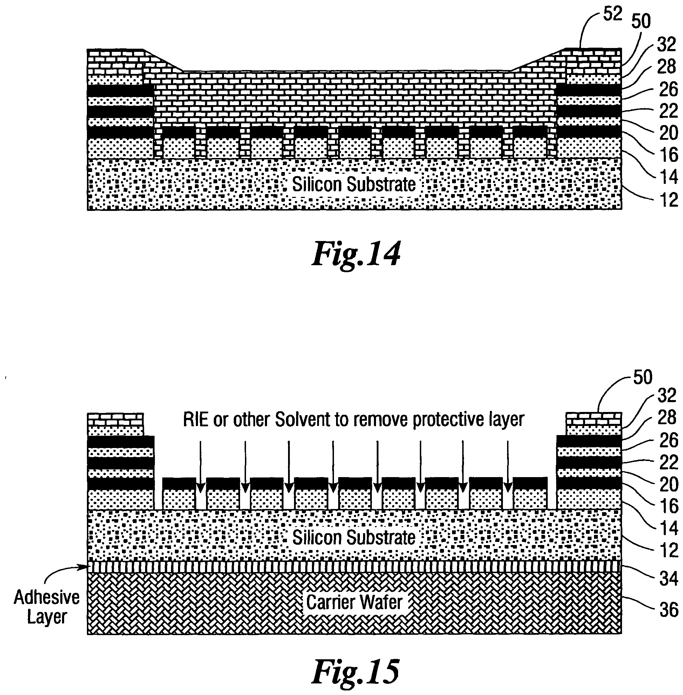

In FIG. 14, a CMP process, back side grinding, RIE, DRIE or other process is performed on the back side of the wafer 10 to thin the wafer to 50 - 100 µm. In FIG. 15, a layer of adhesive 34 is used to attach the first carrier wafer 36 to the back side of the substrate 14. Openings (not shown) may be provided in the first carrier wafer 36 and/or adhesive layer 34 to provide for cooling of the substrate 12. Additionally, those of ordinary skill in the art will recognize that, depending on the amount of substrate 14 being removed and the process being performed, it may be necessary to attach a temporary carrier wafer (not shown) to the top side of wafer 10 to provide support for the thinning process. If such a temporary support is needed, it is removed after first carrier wafer 36 is attached as shown in FIG. 15.

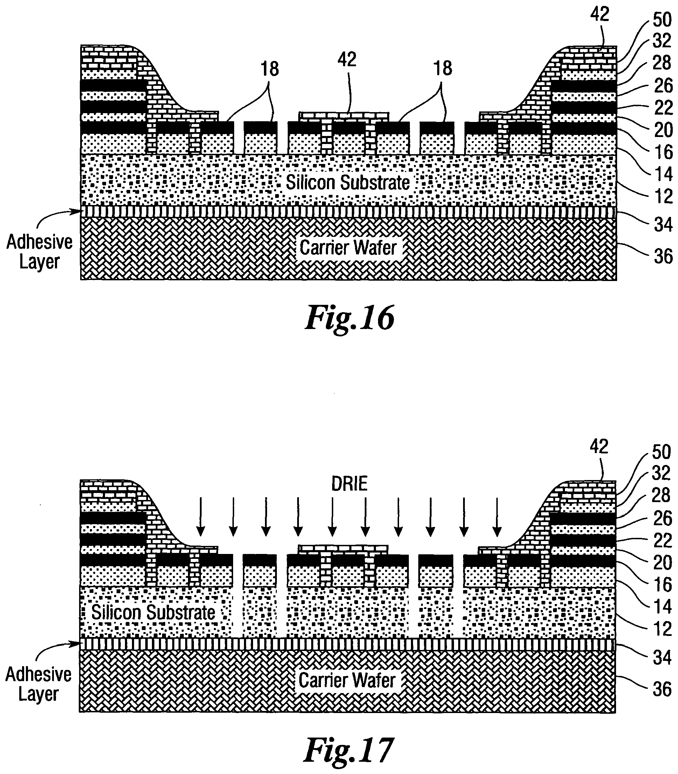

The process continues as shown in FIG. 16 - 18 which are the same as FIGs. 6 - 8, respectively. Thereafter, singulation may be performed using either the method of FIG. 9 or FIG. 10.

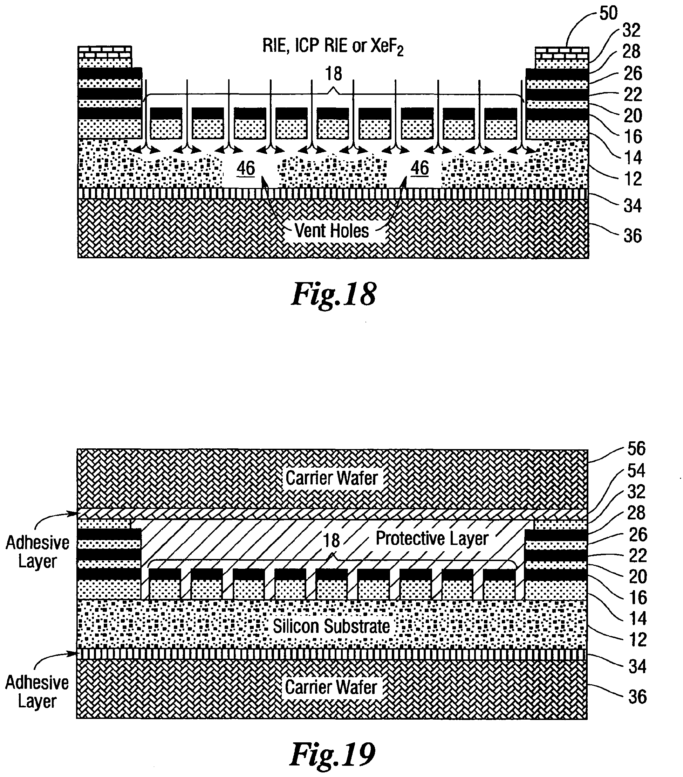

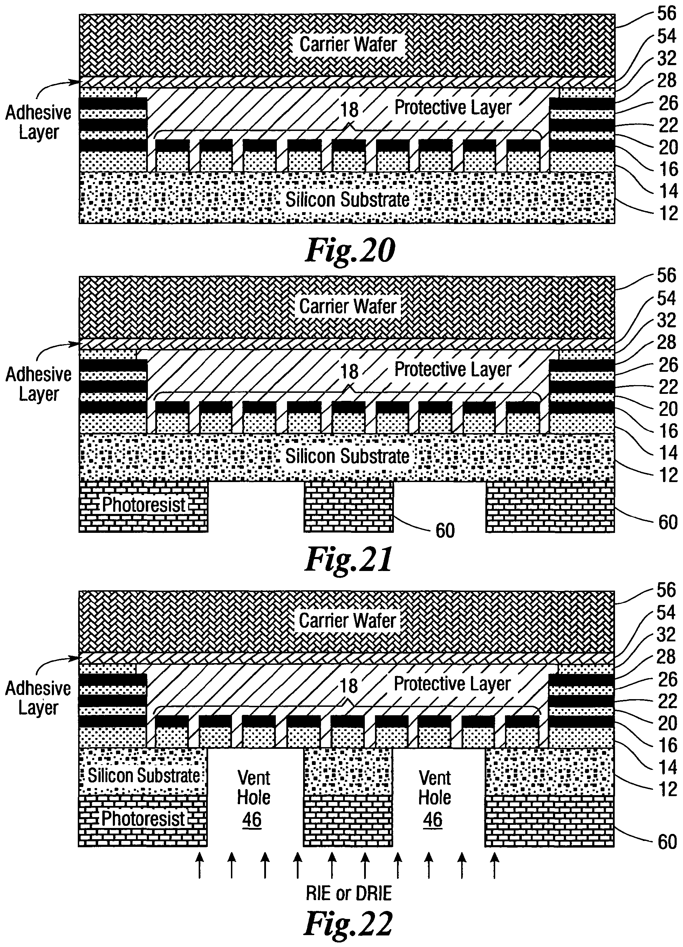

Another embodiment is illustrated in conjunction with FIGs. 1 - 5 and 19 - 25. In this embodiment, the process as discussed in conjunction with FIGs. 1 -5 is carried out as discussed above. However, upon forming the mesh 18 as shown in FIG. 5, the process continues as shown in FIG. 19. In FIG. 19, the wafer 10 is bonded via a layer of adhesive 54 to a second carrier wafer 56 on the top side of the wafer 10. The resist 38 illustrated in FIG. 5 may or may not be removed before the bonding step. Thereafter, as shown in FIG. 20, the first carrier wafer 36 is detached from the wafer 10 using any method appropriating for de-adhering layer 34.

Turning now to FIG. 21, a layer of resist 60 is formed and patterned to provide openings for fabrication of the vent holes. Those of ordinary skill in the art will realize that landmarks from the top side of the wafer 10 need to be transferred to the back side to provide landmarks for registration of the mask needed to pattern the layer of resist 60. Transferring such landmarks is known in the art and therefore not described herein. After the layer of resist 60 has been patterned, the wafer 10 is subjected to RIE or DRIE as shown in FIG. 22 to fabricate vent holes 46.

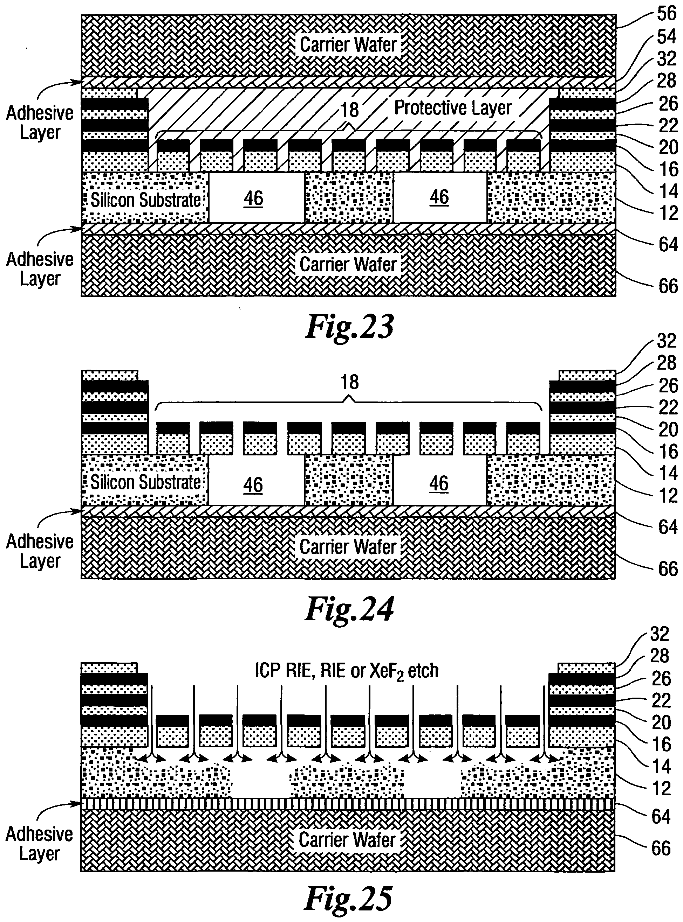

In FIG. 23, the wafer 10 is bonded to a third carrier wafer 66 with a layer of adhesive 64. The resist from the previous step may be removed by any appropriate means, such as oxygen plasma cleaning. The second carrier wafer 56 is detached from the wafer 10 by de-adhering the layer of adhesive 54 resulting in the structure illustrated in FIG. 24. Any protective layers that have been provided can be removed by appropriate methods. An isotropic etch of the silicon substrate 12 is performed to release the mesh 18 from the substrate and to further enlarge the vent holes 46. Thereafter, singulation may be performed as discussed above with either FIGs. 9 or 10.

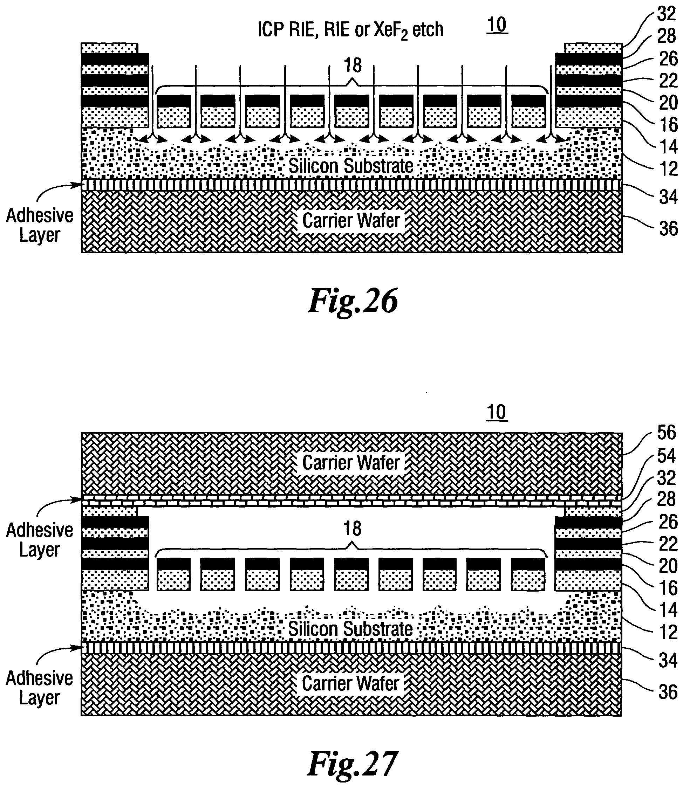

Another embodiment is illustrated in conjunction with FIGs. 1 - 5 and 26 - 30. In this embodiment, the process as discussed above in conjunction with FIGs. 1 -5 is carried out as discussed above. However, in this embodiment, the mesh 18 is released as shown in FIG. 26 by, for example, an isotropic etch of the silicon substrate 12. The wafer 10 is bonded to the second carrier wafer 56 through the use of a layer of adhesive 54 on the top side of the wafer 10 as illustrated in FIG 27.

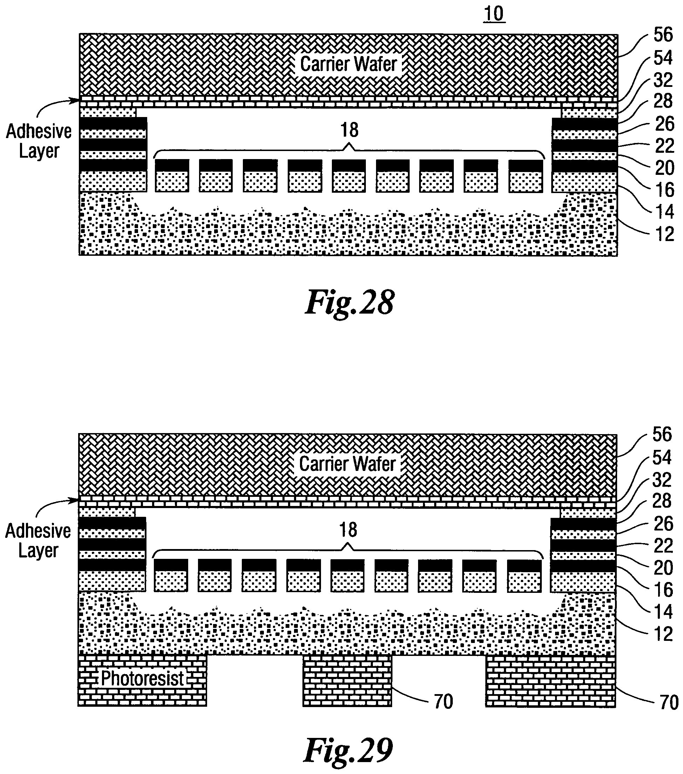

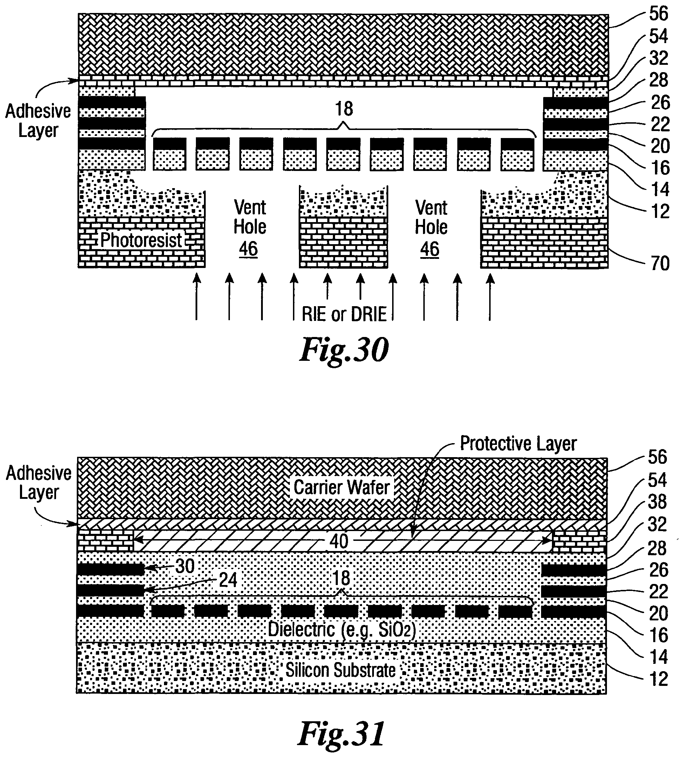

Turning now to FIG. 28, the first carrier wafer 36 is detached from the wafer 10 by de-adhering adhesive layer 34. In FIG. 29, a layer of resist 70 has been formed and patterned on the back side of the wafer 10 to provide for fabrication of the vent holes. In FIG. 30, an RIE or DRIE process is performed to fabricate the vent holes 46. The resist 70 may be stripped off at the end of the etch. Because this is a through wafer etch process, singulation of the chips can be completed at the same time as the vent holes 46 are fabricated as discussed above in conjunction with FIG 9. Alternatively, singulation may be performed using a dicing saw as discussed above in conjunction with FIG 10.

Another embodiment is illustrated in conjunction with FIGs. 1 - 4 and 31 - 38. In this embodiment, the process as discussed above in conjunction with FIGs. 1 -4 is carried out as discussed above. After the wafer 10 has been processed as shown in FIG. 4, the wafer 10 is bonded to the second carrier wafer 56, using a layer of resist 54 and the first carrier wafer 36 is removed by de-adhering the layer of adhesive 34 resulting in the structure illustrated in FIG. 31.

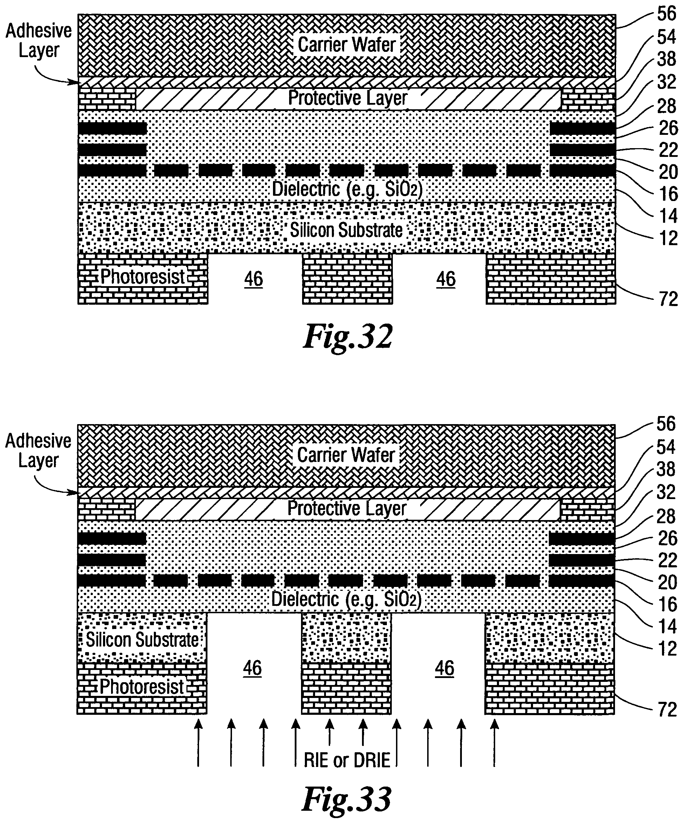

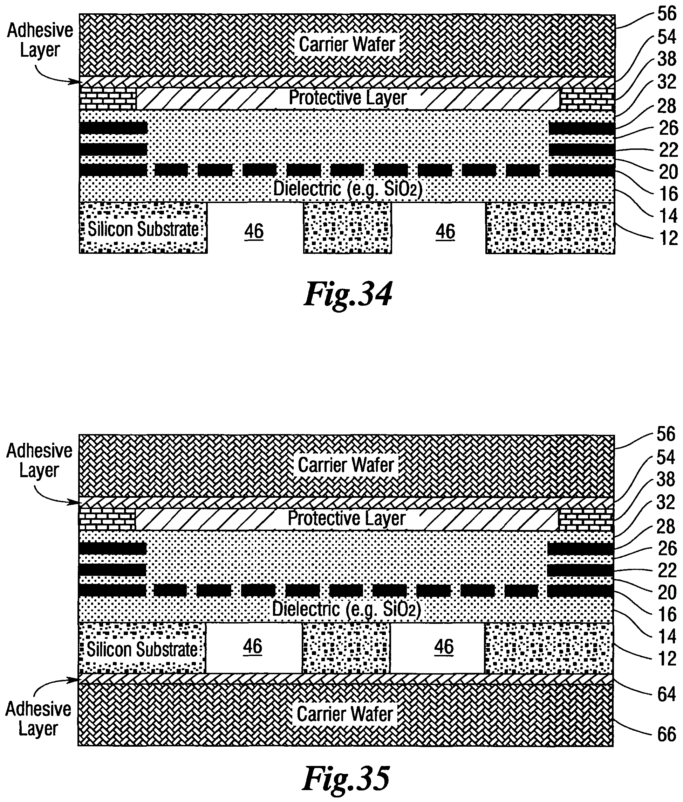

In FIG. 32, the back side of the wafer 10 has a layer of resist 72 formed and patterned as shown in the figure. An RIE or DRIE is performed as shown in FIG. 33 to fabricate the vent holes 46. The resist 72 on the back side of the wafer is then removed as shown in FIG. 34.

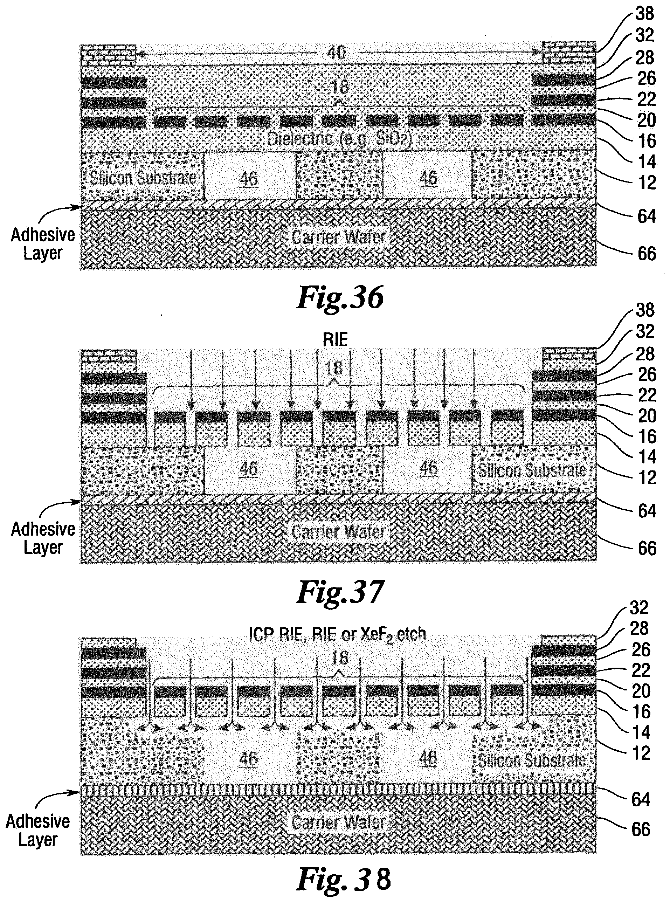

Turning now to FIG. 35, the third carrier wafer 66 is bonded to the back side of wafer 10 with a layer of adhesive 64. In FIG. 36, the second carrier wafer 56 is removed from the wafer 10 by de-adhering the layer of adhesive 54. In FIG. 37, an isotropic etch through the dielectric layers 32, 26, 20 and 14 is performed to form the mesh 18. In FIG. 38, an isotropic etch of the silicon substrate 12 is performed to release the mesh 18 and to enlarge the vent holes 46. Because this is a through-wafer etch process, the separation of the chips can be completed at the same time as discussed above in conjunction with FIG. 9. Alternatively, because of the carrier wafer, singulation can be performed before the device is completely fabricated by taking advantage of any through-wafer etch processes. For example, singulation could occur along with the etching of the substrate shown in FIG. 34. As another alternative, the wafer 10 can be diced with a dicing saw as discussed above in conjunction with FIG. 10.

Completing the process, the mesh 18 of any of the embodiments may be sealed using known deposition techniques to form a membrane capable of operating as a speaker or a microphone.

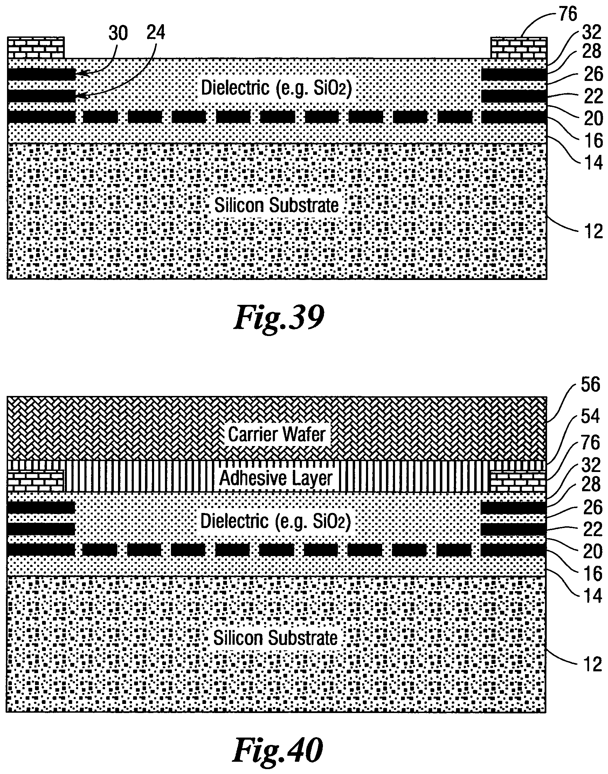

FIG. 1 and FIGs. 39 - 48 illustrate another embodiment of the present invention. FIG. 39 illustrates the substrate of FIG. 1 after a layer of resist 76 has been formed and patterned. The reader will understand that the layer of resist may be formed and patterned latter in the process, or eliminated altogether, as will be noted later. FIG. 40 illustrates the substrate of FIG. 39 after the carrier wafer 56 is attached to the substrate with the adhesive layer 54, which may include optional cushion material. Carrier wafer 56 has been previously identified as the second carrier wafer, although in this embodiment it is the first carrier wafer connected to the substrate.

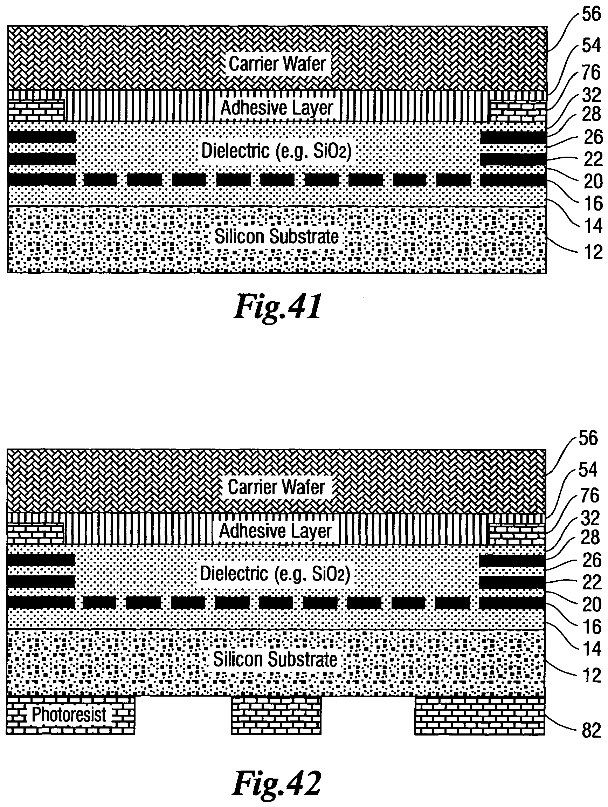

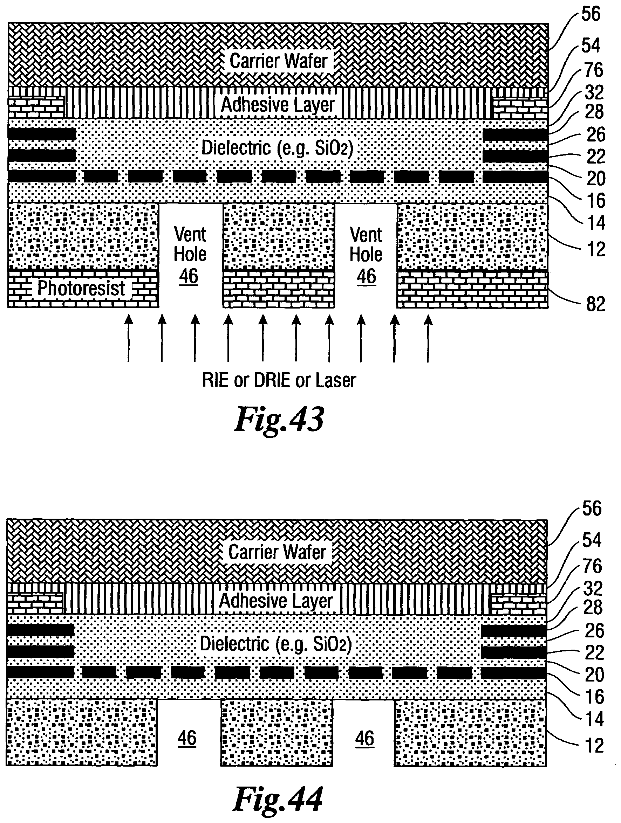

Fig. 41 illustrates the substrate of FIG. 40 after the substrate has been thinned (reduced in thickness) using any known method, including those previously described. FIG. 42 illustrates the substrate of FIG. 41 after a layer of resist 82 has been formed and patterned. Thereafter, and as shown in FIG. 43, the substrate is subjected to an anisotropic etch process to fabricate vent holes 46. Thereafter, as shown in FIG. 44, resist 82 is removed.

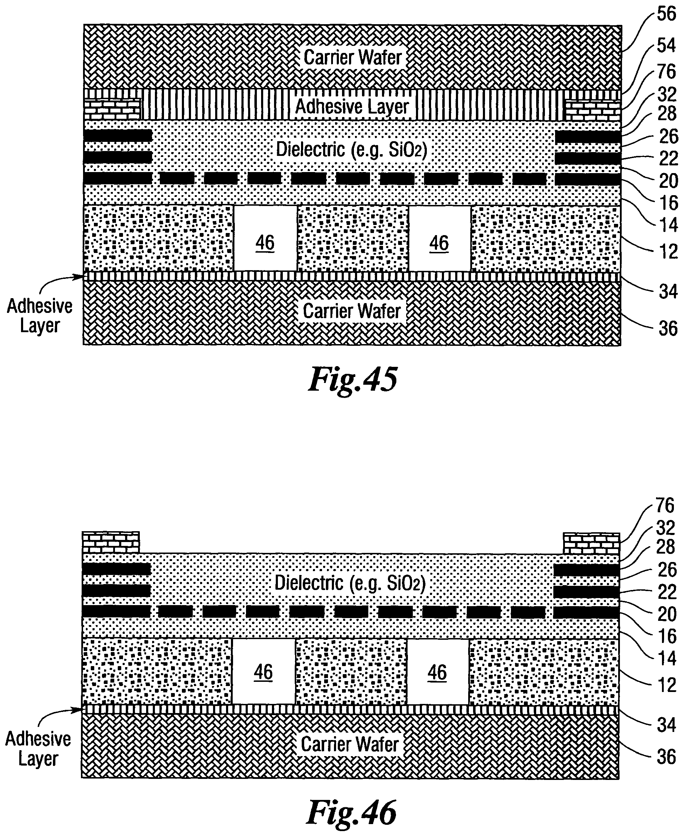

FIG. 45 illustrates the attachment of the carrier wafer 36 to the substrate through the use of adhesive layer 34. In this embodiment, the carrier wafer 36 is the second carrier wafer to be attached to the substrate. The carrier wafer 56 and adhesive layer 54 are then removed as shown in FIG. 46. If the layer of resist 76 has not been previously formed, it may be formed and patterned at this time. If it is not necessary to protect the top layer of dielectric 32, the layer of resist 76 may be eliminated.

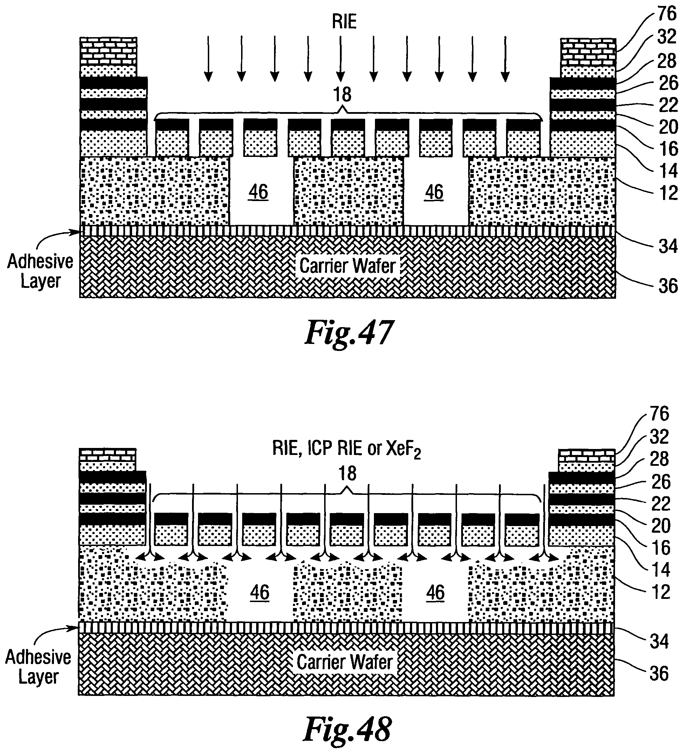

FIG. 47 illustrates the substrate 12 being subjected to an anisotropic etch through dielectric layers 32, 26, 20 and 14 to form the mesh 18. FIG. 48 illustrates the substrate of FIG. 47 being subjected to an isotropic etch so as to release the mesh 18 from the substrate 12 by removal of the substrate material from under the mesh 18. Other forms of releasing the mesh 18 could be provided, such as removal of a sacrificial layer (not shown). Once the mesh 18 is released, the plurality of devices carried by the substrate may be singulated, either before or after sealing of the mesh 18 to form a membrane.

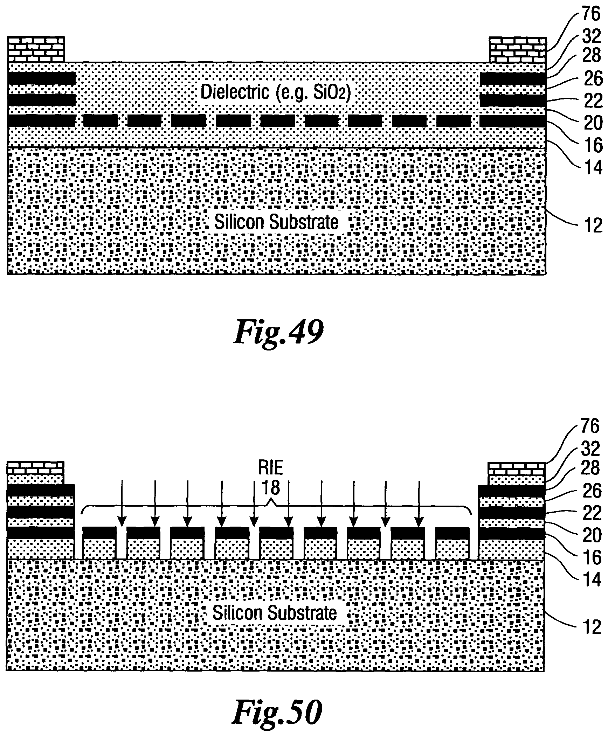

FIG. 1 and FIGs. 49 - 58 illustrate another embodiment of the present invention. FIG. 49 illustrates the substrate of FIG. 1 after a layer of resist 76 has been formed and patterned. The reader will understand that the layer of resist 76 may be formed and patterned latter in the process, or eliminated altogether, as previously described.

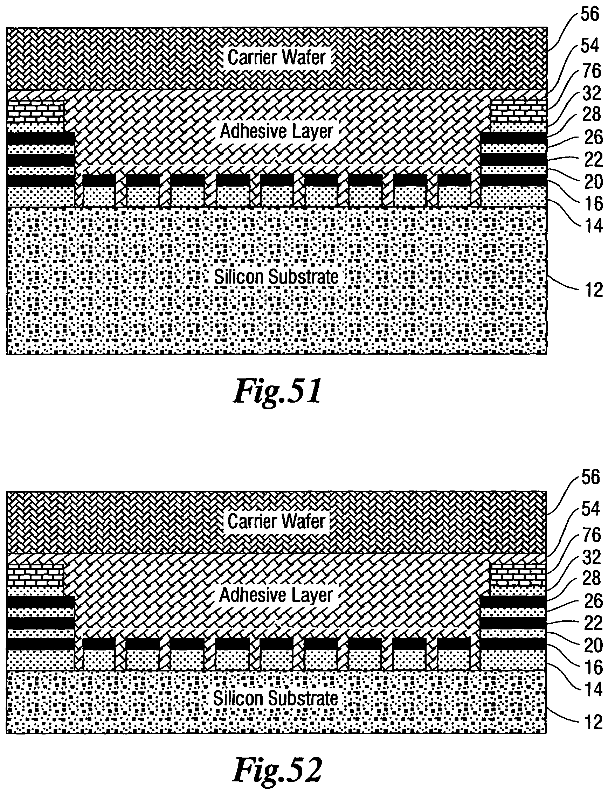

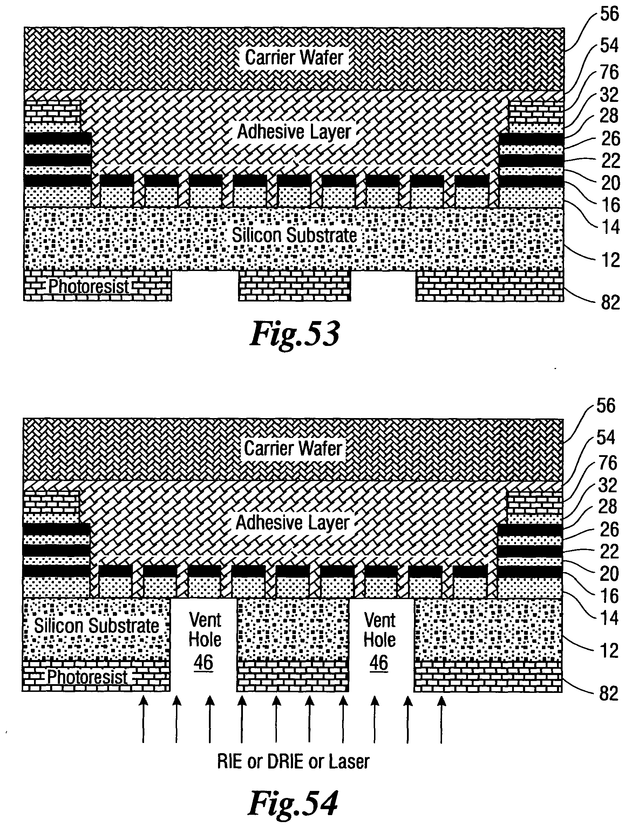

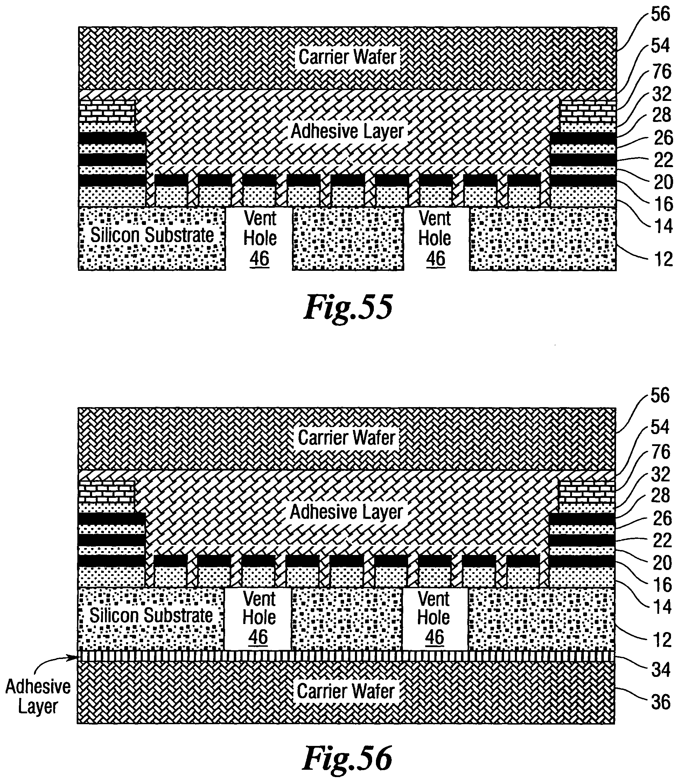

FIG. 50 illustrates the substrate 12 being subjected to an anisotropic etch through dielectric layers 32, 26, 20 and 14 to form the mesh 18. FIG. 51 illustrates the carrier wafer 56 attached to the substrate with the adhesive layer 54, which may include optional cushion material. Thereafter, as shown in FIG. 52, the substrate is thinned (reduced in thickness) using any known method, including those previously described. FIG. 53 illustrates the substrate of FIG. 52 after a layer of resist 82 has been formed and patterned on the back side. Thereafter, and as shown in FIG. 54, the substrate is subjected to an anisotropic etch process to fabricate vent holes 46. Thereafter, as shown in FIG. 55, resist 82 is removed.

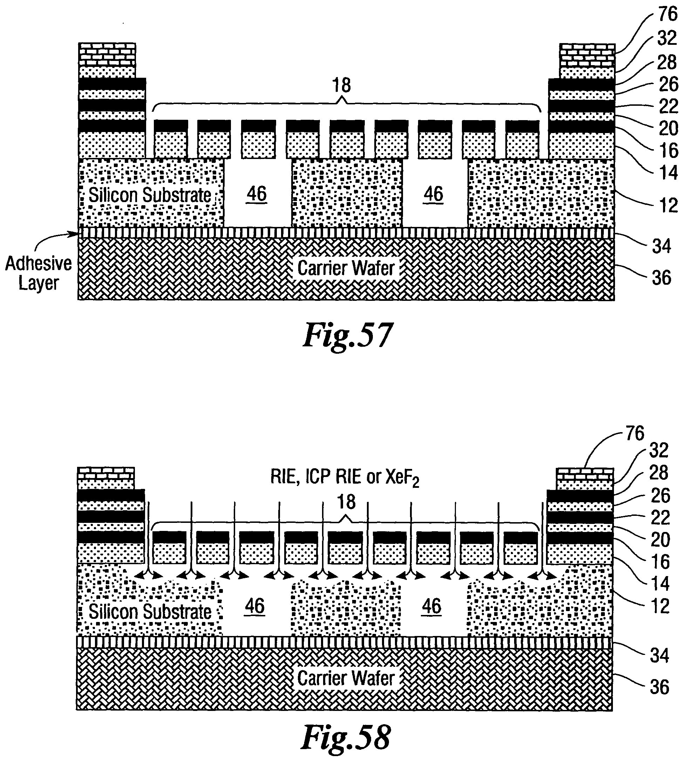

FIG. 56 illustrates the substrate of FIG. 55 after the carrier wafer 36 has been attached to the back side of the substrate using the adhesive layer 34. The carrier wafer 56 is then removed along with the layer of adhesive 54 as shown in FIG. 57. If the layer of resist 76 has not been previously formed, it may be formed and patterned at this time. If it is not necessary to protect the top layer of dielectric 32, the layer of resist 76 may be eliminated.

FIG. 58 illustrates the substrate of FIG. 57 being subjected to an isotropic etch so as to release the mesh 18 from the substrate 12 by removal of the substrate material from under the mesh 18. Other forms of releasing the mesh 18 could be provided, such as removal of a sacrificial layer (not shown). Once the mesh 18 is released, the plurality of devices carried by the substrate may be singulated, either before or after sealing of the mesh 18 to form a membrane.

This disclosure describes a simplified process for making vent holes while eliminating the need for acoustic cavities in each chip for a CMOS MEMS based microphone or microspeaker. Certain of the disclosed embodiments are performed entirely from the top side of the wafer thereby eliminating the need for back side alignment of vent holes relative to the mesh. By reducing the wafer thickness to a specified thickness with standard processes, which are capable of achieving well controlled uniformity across the wafer, the length of the vent holes can be well defined. Therefore, the etch time of a vent hole can be well defined and optimized. Moreover, instead of using special and expensive techniques to etch deep, narrow vent holes, standard RIE techniques can be used to etch the vent holes. This allows for the post-CMOS production to be transferred into a standard CMOS foundry. By integrating chip dicing with the post-CMOS process, manufacturing costs associated with the dicing and separation process can be reduced. By integrating chip dicing with the post-CMOS process, the extra chip size required for dicing with traditional dicing saws may be eliminated.

While the present disclosure has been described in connection with preferred embodiments thereof, those of ordinary skill in the art will recognize that many modifications and variations are possible. The present disclosure is intended to be limited only by the following claims and not by the foregoing description which is intended to set forth the presently preferred embodiments.

## Claims

1. A process for fabricating a MEMS device, comprising:
reducing the thickness of a substrate (12) carrying a plurality of devices on a front side of the substrate (12), at least certain of the plurality of devices having respective micro-machined meshes (18);
subsequent to the reducing of the thickness of the substrate (12), attaching a first carrier wafer (36) to a back side of the substrate (12) for at least a portion of the fabrication process;
performing fabrication steps on the front side of the substrate (12) while the first carrier wafer (36) is attached to the back side of the substrate (12); and
subsequent to said performing of said fabrication steps, releasing said micro-machined meshes (18).

2. The process of claim 1 wherein said plurality of devices are singulated after fabrication.

3. The process of claim 1 wherein said fabrication steps comprise: fabricating vent holes (46) that connect through the substrate (12) in at least certain of the areas where the released meshes are located.

4. The process of claim 2 wherein said singulating said plurality of devices is performed substantially simultaneously with said releasing.

5. The process of claim 4 additionally comprising:
removing said first carrier wafer (36).

6. The process of claim 3 wherein said singulating said plurality of devices is performed substantially simultaneously with said fabricating.

7. The process of claim 6 additionally comprising:
removing said first carrier wafer (36).

8. The process of claim 3 wherein said fabricating is performed after said releasing.

9. The process of claim 3 wherein said fabricating is performed simultaneously with said releasing.

10. The process of claim 3 wherein said fabricating comprises using said micro-machined meshes (18) as an etch mask.

11. The process of claim 3 wherein said fabricating comprises: forming pilot openings (44) in said substrate (12) by using at least portions of certain of said micro-machined meshes (18) as an etch mask, and wherein said releasing said micro-machined meshes (18) comprises removing a portion of substrate (12) beneath the meshes, and fabricating vent holes (46) substantially simultaneously with said releasing by enlarging said pilot openings (44).

12. The process of claim 11 wherein an anisotropic etch is used to form said pilot openings (44) and an isotropic etch is used for releasing the meshes and fabricating the vent holes (46).

13. The process of claim 1, additionally comprising:
attaching a second carrier wafer (56) to the top side of the substrate (12) and removing said first carrier wafer (36) from the back side of the substrate (12);
fabricating vent holes (46) from the back of the substrate (12); and
singulating said devices.

14. The process of claim 13 wherein said singulating is performed substantially simultaneously with said releasing.

15. The process of claim 14 additionally comprising:
removing said second carrier wafer (56) after said singulating.

16. The process of claim 13 wherein said singulating comprises dicing the substrate (12).

17. The process of claim 16 additionally comprising:
removing said second carrier wafer (56) after said dicing.

18. The process of claim 13, additionally comprising:
attaching a third carrier wafer (66) to the back side of the substrate (12) and removing the second carrier wafer (56) from the top side of the substrate (12).

19. The process of claim 13, additionally comprising:
patterning a resist to define said micro-machined meshes (18); and
attaching a third carrier wafer (66) to the back side of the substrate (12) and removing the second carrier wafer (56) from the top side of the substrate (12).

20. The process of claim 18 or 19 wherein said singulating is performed substantially simultaneously with said releasing.

21. The process of claim 20 additionally comprising:
removing said third carrier wafer (66) after said singulating.

22. The process of claim 18 or 19 wherein said singulating comprises dicing the substrate (12).

23. The process of claim 22 additionally comprising:
removing said third carrier wafer (66) after said dicing.

24. The process of claim 1 wherein
a second carrier wafer (56) is attached to the top side of the substrate (12) and the first carrier wafer (36) is removed from the back side of the substrate (12) to enable process steps to be performed from the back side of the substrate (12).

25. The process of claim 1 additionally comprising:
attaching a second carrier wafer (56) to said top side of said substrate (12), at least certain process steps being performed from said back side of said substrate (12) while said second carrier wafer (56) is attached; wherein said micro-machined meshes (18) are released from said top side.

## Patentansprüche

1. Verfahren zur Herstellung einer MEMS-Vorrichtung (24), umfassend:
Verringern der Dicke eines Substrats (12), das auf einer Vorderseite eine Vielzahl von Vorrichtungen trägt, wobei mindestens einige der Vielzahl von Vorrichtungen jeweils mikrobearbeitete Gitter (18) aufweisen;
im Anschluss an das Verringern der Dicke des Substrats (12), Aufbringen eines ersten Trägerwafers (36) auf einer Rückseite des Substrats (12) für mindestens einen Teil des Herstellungsverfahrens;
Ausführen von Herstellungsschritten auf der Vorderseite des Substrats (12), während der erste Trägerwafer (36) auf der Rückseite des Substrats (12) aufgebracht ist; und im Anschluss an die Ausführung der Herstellungsschritte, Ablösen der mikrobearbeiteten Gitter (18).

2. Verfahren nach Anspruch 1, wobei die Vielzahl von Vorrichtungen nach der Herstellung vereinzelt werden.

3. Verfahren nach Anspruch 1, wobei die Herstellungsschritte folgendes umfassen: Herstellen von Lochöffnungen (46), die in mindestens einigen Bereichen, wo die abgelösten Gitter angeordnet sind, durchkontaktiert sind.

4. Verfahren nach Anspruch 2, wobei das Vereinzeln der Vielzahl von Vorrichtungen im Wesentlichen gleichzeitig mit dem Ablösen durchgeführt wird.

5. Verfahren nach Anspruch 4, das überdies folgenden Schritt umfasst: Ablösen des ersten Trägerwafers (36).

6. Verfahren nach Anspruch 3, wobei das Vereinzeln der Vielzahl von Vorrichtungen im Wesentlichen gleichzeitig mit dem Herstellen durchgeführt wird.

7. Verfahren nach Anspruch 6, das überdies folgenden Schritt umfasst: Ablösen des ersten Trägerwafers (36).

8. Verfahren nach Anspruch 3, wobei das Herstellen nach dem Ablösen durchgeführt wird.

9. Verfahren nach Anspruch 3, wobei das Herstellen gleichzeitig mit dem Ablösen durchgeführt wird.

10. Verfahren nach Anspruch 3, wobei das Herstellen die Verwendung der mikrobearbeiteten (18) als Ätzmaske umfasst.

11. Verfahren nach Anspruch 3, wobei das Herstellen folgendes umfasst: Bilden von Pilotöffnungen (44) in dem Substrat (12), indem mindestens Teile einiger mikrobearbeiteter Gitter (18) als Ätzmaske verwendet werden, und wobei das Ablösen der mikrobearbeiteten Gitter (18) das Entfernen eines Teils des Substrats (12) unterhalb der Gitter umfasst sowie das Herstellen von Lochöffnungen (46) im Wesentlichen gleichzeitig mit dem Ablösen, indem die Pilotöffnungen (44) vergrößert werden.

12. Verfahren nach Anspruch 11, wobei zum Bilden der Pilotöffnungen (44) ein anisotropes Ätzen und zum Ablösen der Gitter und Herstellen der Lochöffnungen (46) ein isotropes Ätzen angewandt wird.

13. Verfahren nach Anspruch 1, das überdies folgende Schritte umfasst:
Aufbringen eines zweiten Trägerwafers (56) auf der Oberseite des Substrats (12) und Ablösen des ersten Trägerwafers (36) von der Rückseite des Substrats (12);
Herstellen von Lochöffnungen (46) von der Rückseite des Substrats (12); und
Vereinzeln der Vorrichtungen.

14. Verfahren nach Anspruch 13, wobei das Vereinzeln im Wesentlichen gleichzeitig mit dem Ablösen durchgeführt wird.

15. Verfahren nach Anspruch 14, das überdies folgenden Schritt umfasst: Ablösen des zweiten Trägerwafers (56) nach dem Vereinzeln.

16. Verfahren nach Anspruch 13, wobei das Vereinzeln das Dicen des Substrats (12) umfasst.

17. Verfahren nach Anspruch 16, das überdies folgenden Schritt umfasst: Ablösen des zweiten Trägerwafers (56) nach dem Dicen.

18. Verfahren nach Anspruch 13, das überdies folgende Schritte umfasst:
Aufbringen eines dritten Trägerwafers (66) auf der Rückseite des Substrats (12) und Ablösen des zweiten Trägerwafers (56) von der Oberseite des Substrats (12).

19. Verfahren nach Anspruch 13, das überdies folgende Schritte umfasst:
Strukturieren einer Resistschicht zur Bestimmung der mikrobearbeiteten Gitter (18); und
Aufbringen eines dritten Trägerwafers (66) auf der Rückseite des Substrats (12) und Ablösen des zweiten Trägerwafers (56) von der Oberseite des Substrats (12).

20. Verfahren nach Anspruch 18 oder 19, wobei das Vereinzeln im Wesentlichen gleichzeitig mit dem Ablösen durchgeführt wird.

21. Verfahren nach Anspruch 20, das überdies folgenden Schritt umfasst: Ablösen des dritten Trägerwafers (66) nach dem Vereinzeln.

22. Verfahren nach Anspruch 18 oder 19, wobei das Vereinzeln das Dicen des Substrats (12) umfasst.

23. Verfahren nach Anspruch 22, das überdies folgenden Schritt umfasst: Ablösen des dritten Trägerwafers (66) nach dem Dicen.

24. Verfahren nach Anspruch 1, wobei
auf der Oberseite des Substrats (12) ein zweiter Trägerwafer (56) aufgebracht wird und der erste Trägerwafer (36) von der Rückseite des Substrats (12) abgelöst wird, um zu ermöglichen, dass von der Rückseite des Substrats (12) Verfahrensschritte durchgeführt werden können.

25. Verfahren nach Anspruch 1, das überdies folgende Schritte umfasst:
Aufbringen eines zweiten Trägerwafers (56) auf der Oberseite des Substrats (12), wobei mindestens bestimmte Verfahrensschritte von der Rückseite des Substrats (12) durchgeführt werden, während der zweite Trägerwafer (56) aufgebracht ist; wobei die mikrobearbeiteten Gitter (18) von der Oberseite abgelöst werden.

## Revendications

1. Procédé pour fabriquer un dispositif à MEMS consistant à:
réduire l'épaisseur d'un substrat (12) portant un ensemble de dispositifs sur la face avant du substrat (12), au moins certains dispositifs de l'ensemble des dispositifs ayant une maille (18) micro-usinée,
après la réduction de l'épaisseur du substrat (12) on fixe une première plaquette de support (36) au dos du substrat (12) pour au moins une partie du procédé de fabrication,
on exécute les étapes de fabrication de la face avant du substrat (12), la première plaquette de support (36) étant fixée au dos du substrat (12) et après avoir exécuté les étapes de fabrication, on dégage les mailles micro-usinées (18).

2. Procédé selon la revendication 1, dans lequel on sépare les uns des autres l'ensemble des dispositifs après leur fabrication.

3. Procédé selon la revendication 1, selon lequel les étapes de fabrication comprennent la fabrication d'orifices de ventilation (46) qui traversent le substrat (12) dans au moins certaines zones où se trouvent les mailles dégagées.

4. Procédé selon la revendication 2, dans lequel la séparation les uns des autres de l'ensemble des dispositifs est effectuée pratiquement en même temps que le dégagement.

5. Procédé selon la revendication 4, comprenant en outre l'enlèvement de la première plaquette de support (36).

6. Procédé selon la revendication 3, dans lequel l'étape de séparation les uns des autres de l'ensemble des dispositifs se fait pratiquement en même temps que la fabrication.

7. Procédé selon la revendication 6, comprenant en outre l'enlèvement de la première plaquette de support (36).

8. Procédé selon la revendication 3, selon lequel on effectue la fabrication après le dégagement.

9. Procédé selon la revendication 3, selon lequel la fabrication se fait en même temps que le dégagement.

10. Procédé selon la revendication 3, selon lequel la fabrication comprend l'utilisation de mailles (18) micro-usinées comme masques de gravure.

11. Procédé selon la revendication 3, selon lequel la fabrication comprend la formation d'orifices pilotes (44) dans le substrat (12) en utilisant au moins les parties de certaines des mailles micro-usinées (18) comme masque de gravure et selon lequel le dégagement des mailles micro-usinées (18) consiste à enlever une partie du substrat (12) sous les mailles et la fabrication des orifices de ventilation (46) se fait pratiquement simultanément avec le dégagement, en agrandissant les orifices pilotes (44).

12. Procédé selon la revendication 11, selon lequel on utilise une gravure anisotropique pour former les orifices pilotes (44) et une gravure isotropique pour dégager les mailles et fabriquer les orifices de ventilation (46).

13. Procédé selon la revendication 1, comprenant en outre
la fixation d'une seconde plaquette de support (56) sur le dessus du substrat (12) et enlèvement de la première plaquette de support (36) du dos du substrat (12),
la fabrication d'orifices de ventilation (46) à partir du dos du substrat (12) et,
la séparation les uns des autres des dispositifs.

14. Procédé selon la revendication 13, selon lequel la séparation les uns des autres se fait pratiquement en même temps que le dégagement.

15. Procédé selon la revendication 14, comprenant en outre l'enlèvement de la seconde plaquette de support (56) après la séparation les uns des autres.

16. Procédé selon la revendication 13, selon lequel la séparation les uns des autres consiste à découper le substrat (12).

17. Procédé selon la revendication 16, comprenant en outre l'enlèvement de la seconde plaquette de support (56) après la découpe.

18. Procédé selon la revendication 13, comprenant en outre
la fixation d'une troisième plaquette de support (66) au dos du substrat (12) et à l'enlèvement de la seconde plaquette de support (56) du dessus du substrat (12).

19. Procédé selon la revendication 13, comprenant en outre
la réalisation d'un motif de résist pour définir des mailles micro-usinées (18) et
fixer une troisième plaquette de support (66) au dos du substrat (12) et enlever la seconde plaquette de support (56) du dessus du substrat (12).

20. Procédé selon la revendication 18 ou 19, selon lequel la séparation les uns des autres se fait pratiquement en même temps que le dégagement.

21. Procédé selon la revendication 20, comprenant en outre l'enlèvement de la troisième plaquette de support (66) après la séparation les uns des autres.

22. Procédé selon la revendication 18 ou 19, selon lequel la séparation les uns des autres consiste à découper le substrat (12).

23. Procédé selon la revendication 22, comprenant en outre l'enlèvement de la troisième plaquette de support (66) après la découpe.

24. Procédé selon la revendication 1, selon lequel on fixe une seconde plaquette de support (56) au côté supérieur du substrat (12) et on enlève la première plaquette de support (36) du dos du substrat (12) pour permettre l'exécution des étapes du procédé à partir du dos du substrat (12).

25. Procédé selon la revendication 1, comprenant en outre
la fixation d'une seconde plaquette de support (56) au-dessus du substrat (12), au moins certaines des étapes du procédé étant exécutées à partir du dos du substrat (12) alors que la seconde plaquette de support (56) est fixée, les mailles micro-usinées (18) étant dégagées à partir du côté supérieur.
